# EUROPÄISCHE PATENTSCHRIFT

(11) **EP 2 619 604 B1**
(45) Veröffentlichungstag und Bekanntmachung des Hinweises auf die Patenterteilung: **06.03.2019**
(21) Anmeldenummer: 11757198.4
(22) Anmeldetag: 19.08.2011
(51) Int. Cl.: G01R 35/00, G01R 31/28, G01R 19/00, G01R 31/00

(54) **VERFAHREN ZUR ÜBERPRÜFUNG DER ORDNUNGSGEMÄSSEN FUNKTIONSWEISE EINES STROMSENSORS**
METHOD FOR CHECKING THE PROPER METHOD OF OPERATION OF A CURRENT SENSOR
PROCÉDÉ POUR VÉRIFIER LE MODE DE FONCTIONNEMENT CORRECT D'UN DÉTECTEUR DE COURANT

(30) Priorität: 23.09.2010 DE 102010041275
(43) Veröffentlichungstag der Anmeldung: 31.07.2013
(73) Patentinhaber: Robert Bosch GmbH, 70442 Stuttgart (DE); SAMSUNG SDI CO., LTD., Yongin-si, Gyeonggi-do 446-577 (KR)
(72) Erfinder: BOEHM, Andre, 70806 Kornwestheim (DE); RISCHEN, Joachim, 74199 Untergruppenbach (DE)
(74) Vertreter: Bee, Joachim
(86) Internationale Anmeldenummer: PCT/EP2011/064256
(87) Internationale Veröffentlichungsnummer: WO 2012/038161

(56) Entgegenhaltungen:
- EP-A2- 0 408 867
- DE-A1- 4 130 978
- DE-A1-102007 061 729
- JP-A- 2002 267 698
- US-A1- 2006 255 766
- US-A1- 2007 115 604

## Beschreibung

Die vorliegende Erfindung betrifft ein Verfahren zur Überprüfung der ordnungsgemäßen Funktionsweise eines Stromsensors, eine Recheneinheit, die dazu ausgelegt ist, das erfindungsgemäße Verfahren auszuführen, eine Batterie mit der erfindungsgemäßen Recheneinheit sowie ein Kraftfahrzeug mit der erfindungsgemäßen Batterie.

### Stand der Technik

Insbesondere in Hybrid- und Elektrofahrzeugen werden heute Batterien in Lithium-Ionen- oder Nickel-Metallhydrid-Technologie eingesetzt, die eine große Anzahl in Serie geschalteter elektrochemischer Batteriezellen aufweisen. Eine Batteriemanagementeinheit wird zur Überwachung der Batterie eingesetzt und soll neben einer Sicherheitsüberwachung eine möglichst hohe Lebensdauer gewähren. Dazu wird die Spannung jeder einzelnen Batteriezelle zusammen mit dem Batteriestrom und der Batterietemperatur gemessen und eine Zustandsschätzung (beispielsweise des Ladezustandes oder des Alterungszustandes der Batterie) vorgenommen. Um die Lebensdauer zu maximieren, ist es hilfreich, jederzeit die aktuell gegebene maximale Leistungsfähigkeit der Batterie, also die maximal abgeb- oder aufnehmbare elektrische Leistung, zu kennen. Wird diese Leistungsfähigkeit überschritten, kann die Alterung der Batterie stark beschleunigt werden.

Um eine genaue Messung des Batteriestroms zu ermöglichen, ist es erforderlich, die ordnungsgemäße Funktionsweise der in der Batteriemanagementeinheit verwendeten Stromsensoren zu überwachen. Insbesondere müssen ein Verstärkungsfaktor und ein Offset jedes verwendeten Stromsensors kalibriert werden. Außerdem kann die Güte der von jedem Stromsensor gelieferten Messdaten eingeschätzt und somit plausibilisiert werden.
Aus dem Stand der Technik sind weiterhin Verfahren zur Begrenzung eines Einschaltstromes in einem an eine Batterie angeschlossenen elektrischen Netz bekannt, bei welchen während eines Einschaltvorgangs eine Vorladung ausgeführt wird, so dass ein Einschaltstrom, welcher durch eine Batterie und einen zugeschalteten Verbraucher fließt, vermindert wird. Eine solche Vorladung kann beispielsweise über einen Vorladewiderstand vorgenommen werden. Hat sich in einem solchen System die Systemspannung an die Batteriespannung angepasst, wird der Vorladewiderstand kurzgeschlossen und somit deaktiviert.

Die Druckschrift DE 10 2007 061 729 A1 beschreibt ein Verfahren zur Erkennung eines elektrischen Fehlers in einem elektrischen Netzwerk eines Kraftfahrzeugs, wobei das elektrische Netzwerk eine Batterie umfasst und wobei die Erkennung des Fehlers mittels eines Vergleichs zweier auf unterschiedliche Arten mittels Sensoren ermittelter Ströme auf ein Überschreiten einer vorgebbaren Abweichung erfolgt

### Offenbarung der Erfindung

Erfindungsgemäß wird ein Verfahren zur Überprüfung der ordnungsgemäßen Funktionsweise eines Stromsensors bereitgestellt. Der Stromsensor ist dazu ausgelegt, einen Batteriestrom zu messen. Typischerweise handelt es sich bei dem Batteriestrom um einen Gesamtstrom, welcher durch eine Vielzahl von in Reihe geschalteten Einzelbatteriezellen fließt. Während einer Vorladephase wird mindestens ein von dem Stromsensor gelieferter Messwert mit einem aus einem erwarteten zeitlichen Verlauf eines Vorladestromes ermittelten Erwartungsstromwert verglichen. Hierbei beginnt die Vorladephase in einem Zeitpunkt, in welchem mindestens eine elektrische Komponente an die Batterie angeschlossen wird. Während der Vorladephase wird die elektrische Komponente durch den Vorladestrom vorgeladen. Dadurch, dass der während der Vorladephase durch die Batterie fließende Vorladestrom in seinem zeitlichen Verlauf bekannt ist, können die hierdurch berechneten Erwartungsstromwerte mit den tatsächlich von dem Stromsensor gemessenen Werten in Einklang gebracht werden.

Das erfindungsgemäße Verfahren stellt ein sehr kostengünstiges Verfahren dar, da eine Plausibilisierung beziehungsweise Kalibrierung der in einer Batterie verwendeten Stromsensoren ohne zusätzliche Betriebskomponenten und nur durch Bereitstellung einer geeigneten Software in einer Steuereinheit der Batteriemanagementeinheit ermöglicht werden können.

Bevorzugt ist, dass die elektrische Komponente während der Vorladephase über einen Vorladewiderstand vorgeladen wird, dessen Größe im Allgemeinen bekannt ist. Außerdem ist bevorzugt, dass die elektrische Komponente ein Kondensator ist und der erwartete zeitliche Verlauf des Vorladestroms während der Vorladephase somit einer Exponentialfunktion entspricht. Wenn die Größe des Vorladewiderstandes sowie die Kapazität des Kondensators bekannt sind, ist es nämlich möglich, den exponentiellen Verlauf des Vorladestromes zu berechnen und daran die von dem Stromsensor gelieferten Messwerte in ihrer Güte einzuschätzen.

In einer weiteren Ausführungsform der Erfindung wird die elektrische Komponente während der Vorladephase mit einem zeitlich konstanten Vorladestrom vorgeladen. Eine solche gleichförmige Vorladung kann durch eine Schaltung umgesetzt werden, welche einen zeitlich konstanten Strom liefert, dessen Größe genau bekannt ist.

Auf Grundlage des Vergleichs des von dem Stromsensor gelieferten Messwerts mit dem Erwartungsstromwert kann eine Plausibilisierung weiterer von dem Stromsensor gelieferter Messwerte durchgeführt werden. Insbesondere kann entschieden werden, ob der Stromsensor defekt ist.

Außerdem kann auf der genannten Grundlage eine Kalibrierung des Stromsensors durchgeführt werden. Hierbei können insbesondere der Verstärkungsfaktor und/oder der Offset des Stromsensors korrigiert werden.

Schon vor Beginn der Vorladephase kann ein von dem Stromsensor gelieferter Messwert zur Überwachung der ordnungsgemäßen Funktionsweise verwendet werden, da zu diesem Zeitpunkt ein vernachlässigbar geringer Batteriestrom fließt und somit ein von Null verschiedener Messwert zum Anlass genommen werden kann, eine entsprechende Korrektur des Offsets des Stromsensors durchzuführen.

Ein weiterer Aspekt der Erfindung betrifft eine Recheneinheit, welche dazu ausgelegt ist, das erfindungsgemäße Verfahren auszuführen.

Ein weiterer Aspekt der Erfindung betrifft eine Batterie mit einer erfindungsgemäßen Recheneinheit sowie ein Kraftfahrzeug, welches eine erfindungsgemäße Recheneinheit oder eine erfindungsgemäße Batterie umfasst. Die erfindungsgemäße Batterie ist bevorzugt eine Lithium-Ionen-Batterie.

### Zeichnungen

Ausführungsbeispiele der Erfindung werden anhand der Zeichnungen und der nachfolgenden Beschreibung näher erläutert. Es zeigen:
Figur 1 ein Ausführungsbeispiel einer erfindungsgemäßen Batterie und
Figur 2 den zeitlichen Verlauf eines Batteriestroms I und einer Spannung U, welche an einer während einer Vorladephase aufgeladenen elektrischen Komponente anliegt.

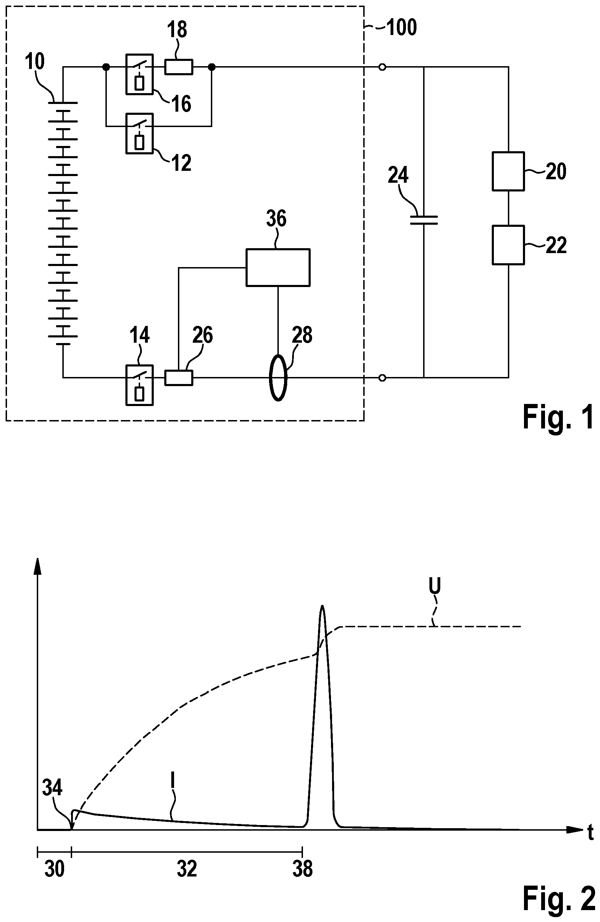

Figur 1 zeigt ein Ausführungsbeispiel einer erfindungsgemäßen, insgesamt mit 100 bezeichneten Batterie. Die Batterie 100 umfasst eine Vielzahl von in Reihe geschalteten Batteriezellen 10, insbesondere Lithium-Ionen-Batteriezellen. Ein nicht dargestelltes elektrisches Kraftfahrzeug umfasst die Batterie 100, an welche im Betriebszustand ein Inverter 20 angeschlossen werden kann, welcher eine von der Batterie 100 gelieferte Gleichspannung in eine Wechselspannung umwandelt, welche einen elektrischen Motor 22 antreibt. Parallel zu dem Inverter 20 und dem elektrischen Motor 22 ist ein Glättungskondensator 24 geschaltet, welcher dazu verwendet wird, einen von dem Inverter 20 erzeugten, hochfrequenten Spannungsrippel zu glätten. An den Polen der Batterie 100 sind ein erstes, positives Relais 12 und ein zweites, negatives Relais 14 vorgesehen, welche geöffnet werden können, um das elektrische Kraftfahrzeug spannungsfrei zu schalten, wenn es von einem Benutzer abgestellt wird. Parallel zum ersten Relais 12 sind ein drittes Relais 16 und ein Vorladewiderstand 18 geschaltet. Am Beginn eines Fahrzyklus werden die Relais 12, 14, 16 in einer vorbestimmten Schaltsequenz zugeschaltet.

Wenn der Vorladewiderstand 18 in der Batterie 100 nicht vorgesehen wäre, würde bei Zuschaltung der elektrischen Komponenten 20, 22, 24 ein hoher Einschaltstrom durch die Batterie 100 fließen, welcher darauf zurückzuführen ist, dass sich der Glättungskondensator 24 auflädt. Um den Einschaltstrom zu begrenzen, wird der Vorladewiderstand 18 durch Schließung des dritten Relais 16 vor die elektrischen Komponenten 20, 22, 24 geschaltet. Wenn der Vorladestrom abgefallen ist beziehungsweise sich die Spannung am Glättungskondensator 24 an die Batteriespannung angepasst hat, wird das dritte Relais 16 geöffnet und das erste Relais 12 geschlossen, wodurch der Vorladewiderstand 18 kurzgeschlossen wird. In dieser Phase ist die weitere Aufladung des Glättungskondensators 24 nur noch durch den Innenwiderstand der Batterie 100 begrenzt. Die Vorladung über den Vorladewiderstand 18 verhindert eine Schädigung des ersten Relais 12.

Die Batterie 100 umfasst Stromsensoren 26, 28, welche dazu ausgelegt sind, den durch die Batteriezellen 10 fließenden Batteriestrom zu messen. Ein erster Stromsensor 26 umfasst einen Shunt-Widerstand, an welchem ein Spannungsabfall gemessen wird. Ein zweiter Stromsensor 28 ist in der Form eines Hall-Sensors vorgesehen, welcher eine Ausgangsspannung liefert, die proportional zum Produkt aus der magnetischen Feldstärke eines ihn durchsetzenden magnetischen Feldes und dem zu messenden Batteriestrom ist. Die Stromsensoren 26, 28 können zu einem vorgegebenen Zeitpunkt einen nicht bekannten Offset und einen nicht bekannten Verstärkungsfaktor haben, welcher beispielsweise im Fall des Hall-Sensors 28 auf die Wirkung einer Hysterese zurückzuführen ist. Die von den Stromsensoren 26, 28 gelieferten Messwerte des Batteriestroms werden einer Recheneinheit in Form eines Mikrocontrollers 36 zugeführt, welcher zusammen mit den Stromsensoren 26, 28 Teil einer nicht dargestellten Batteriemanagementeinheit ist. Der Mikrocontroller 36 steuert außerdem die Relais 12, 14, 16 an (in Figur 1 nicht dargestellt).

Während einer Vorladephase, während derer das erste Relais 12 geöffnet und die beiden anderen Relais 14, 16 geschlossen sind, wird der Glättungskondensator 24 über den Vorladewiderstand 18 aufgeladen, wobei ein zeitlicher Verlauf des durch die Batterie 100 und insbesondere den Vorladewiderstand 18 fließenden Vorladestroms bekannt ist und auf Grundlage der bekannten Größe des Vorladewiderstandes 18 und der Kapazität des Glättungskondensators 24 berechnet werden kann. In dem Mikrocontroller 36 ist der erwartete zeitliche Verlauf des Vorladestromes hinterlegt. Während der Vorladephase vergleicht der Mikrocontroller 36 die beiden von den Stromsensoren 26, 28 zu einem vorbestimmten Zeitpunkt gelieferten Messwerte mit dem diesem Zeitpunkt entsprechenden Erwartungsstromwert, welcher aus dem berechneten und im Mikrocontroller 36 hinterlegten zeitlichen Verlauf des Vorladestroms ermittelt wird. Der Mikrocontroller 36 stellt gegebenenfalls zu einem späteren Zeitpunkt einen weiteren Vergleich der Stromwerte an. Auf Grundlage des Vergleichs führt der Mikrocontroller 36 eine Kalibrierung der Stromsensoren 26, 28 durch und korrigiert insbesondere die Verstärkungsfaktoren und/oder Offsets der Stromsensoren 26, 28. Erfolgt keine Kalibrierung der Stromsensoren 26, 28, so kann zumindest eine Plausibilisierung weiterer von den Stromsensoren 26, 28 gelieferter Messwerte durchgeführt werden. Hierbei entscheidet der Mikrocontroller 36, ob die Abweichung der von den Stromsensoren 26, 28 gelieferten Messwerte von dem berechneten Erwartungsstromwert unter einer vorbestimmten Schwelle liegt, beispielsweise einer prozentualen Toleranzschwelle. Übersteigt die Abweichung die vorbestimmte Schwelle, generiert der Mikrocontroller 36 ein Warnsignal, welches anzeigt, dass mindestens einer der Stromsensoren 26, 28 defekt ist.

Figur 2 zeigt einen erwarteten zeitlichen Verlauf eines Batterie-/Vorladestroms I sowie einer an dem Glättungskondensator 24 anliegenden Spannung U. In einer Trennphase 30, welche einer Vorladephase 32 vorgelagert ist, sind alle drei Relais 12, 14, 16 der Batterie 100 geöffnet, so dass kein Batteriestrom I fließt. Die Stromsensoren 26, 28 können dahingehend plausibilisiert werden, dass sie bei ordnungsgemäßer Funktionsweise keinen Strom messen dürfen. In der Trennphase 30 kann insbesondere eine einfache Kalibrierung des Offsets der beiden Stromsensoren 26, 28 vorgenommen werden.

Die Vorladephase 32 beginnt in einem Zeitpunkt 34, in welchem die elektrischen Komponenten 20, 22, 24 dadurch an die Batterie 100 angeschlossen werden, dass in diesem Zeitpunkt das zweite, negative Relais 14 und das dritte Relais 16 geschlossen werden. In der Vorladephase 32 wird der Glättungskondensator 24 durch einen exponentiell verlaufenden Vorladestrom I aufgeladen. Da sowohl der Kapazitätswert des Glättungskondensators 24 als auch der Widerstandswert des Vorladewiderstandes 18 bekannt sind, kann der erwartete zeitliche Verlauf des Vorladestroms I in der Vorladephase 32 berechnet und im Mikrocontroller 36 hinterlegt werden. Ähnliches gilt für den erwarteten zeitlichen Verlauf der Spannung U, welche an dem Glättungskondensator 24 anliegt. Alternativ kann der erwartete zeitliche Verlauf des Vorladestroms I durch einen Vergleich der gemessenen Spannungen, welche an dem Glättungskondensator 24 (U_{C}) beziehungsweise an der Vielzahl von Batteriezellen 10 (U_{B}) anliegen, gemäß der Formel I = (U_{B} - U_{C}) / R berechnet werden, wobei R der Widerstandswert des Vorladewiderstandes 18 ist. Aus dem erwarteten zeitlichen Verlauf des Batteriestroms I werden vom Microcontroller 36 für verschiedene Zeitpunkte Erwartungsstromwerte ermittelt.

Die tatsächlich von den Stromsensoren 26, 28 gelieferten Strommesswerte werden in verschiedenen Zeitpunkten während der Vorladephase 32 durch den Mikrocontroller 36 mit den entsprechenden Erwartungsstromwerten verglichen, wodurch die Güte jedes einzelnen Sensors 26, 28 eingeschätzt werden kann. In einem Zeitpunkt 38, zu dem der Vorladestrom I (gemessen oder berechnet) unterhalb einer vorbestimmten Schwelle liegt, wird das erste Relais 12 geschlossen, wodurch eine Spitze des Batteriestroms I erzeugt wird, da die Aufladung des Glättungskondensators 24 nur noch durch den Innenwiderstand der Batterie 100 begrenzt ist. Sollte der Verlauf der Stromspitze im Zeitpunkt 38 hinreichend bekannt sein, so lässt sich das erfindungsgemäße Verfahren auch in dieser Phase, welche der Vorladephase 32 nachgeschaltet ist, ausführen.

## Patentansprüche

1. Verfahren zur Überprüfung der ordnungsgemäßen Funktionsweise eines Stromsensors (26, 28), welcher dazu ausgelegt ist, einen Batteriestrom einer Batterie (100) zu messen, **dadurch gekennzeichnet, dass** während einer Vorladephase (32), die zu einem Zeitpunkt (34) beginnt, in welchem mindestens ein Kondensator (24) an die Batterie (100) angeschlossen wird und während derer der Kondensator (24) durch einen vom Stromsensor (26, 28) gemessenen Vorladestrom vorgeladen wird, mindestens ein von dem Stromsensor gelieferter Messwert durch eine Recheneinheit (36) mit einem aus einem erwarteten und in der Recheneinheit (36) hinterlegten zeitlichen Verlauf des Vorladestromes ermittelten Erwartungsstromwert verglichen wird und auf Grundlage des Vergleichs des von dem Stromsensor (26, 28) gelieferten Messwerts mit dem Erwartungsstromwert eine Plausibilisierung weiterer von dem Stromsensor (26, 28) gelieferter Messwerte durchgeführt wird, insbesondere entschieden wird, ob der Stromsensor (26, 28) defekt ist.

2. Verfahren nach Anspruch 1, wobei die elektrische Komponente (20, 22, 24) während der Vorladephase (32) über einen Vorladewiderstand (18) vorgeladen wird.

3. Verfahren nach Anspruch 2, wobei die elektrische Komponente (20, 22, 24) ein Kondensator (24) ist und der erwartete zeitliche Verlauf des Vorladestromes während der Vorladephase (32) einer Exponentialfunktion entspricht.

4. Verfahren nach Anspruch 1, wobei die elektrische Komponente (20, 22, 24) während der Vorladephase (32) mit einem zeitlich konstanten Vorladestrom vorgeladen wird.

5. Verfahren nach einem der vorangehenden Ansprüche, wobei auf Grundlage des Vergleichs des von dem Stromsensor (26, 28) gelieferten Messwerts mit dem Erwartungsstromwert eine Kalibrierung des Stromsensors (26, 28) durchgeführt wird, und insbesondere sein Verstärkungsfaktor und/oder sein Offset korrigiert wird.

6. Verfahren nach einem der vorangehenden Ansprüche, wobei mindestens ein vor dem Beginn der Vorladephase (32) von dem Stromsensor (26, 28) gelieferter Messwert dazu verwendet wird, eine Korrektur des Offsets des Stromsensors (26, 28) durchführen.

7. Vorrichtung, umfassend einen Mikrocontroller (36) und einen Stromsensor (26, 28), welcher dazu ausgelegt ist, einen Batteriestrom zu messen, **dadurch gekennzeichnet, dass** sie dazu ausgelegt ist, ein Verfahren nach einem der vorangehenden Ansprüche auszuführen.

8. Batterie (100) mit einer Vorrichtung nach Anspruch 7.

9. Kraftfahrzeug, insbesondere elektrisches Kraftfahrzeug, umfassend eine Vorrichtung nach Anspruch 7 oder eine Batterie (100) nach Anspruch 8.

## Claims

1. Method for checking the proper method of operation of a current sensor (26, 28) that is designed for the purpose of measuring a battery current of a battery (100), **characterized in that** during a pre-charge phase (32) that commences at a point in time (34) at which at least one capacitor (24) is connected to the battery (100) and during said pre-charge phase the capacitor (24) is pre-charged by way of a pre-charge current that is measured by the current sensor (26, 28), at least one measured value that is supplied by the current sensor is compared by means of a computation unit (36) with an expected current value that is determined from an expected progression with respect to time of the pre-charge current that is stored in the computation unit (36) and on the basis of comparing the measured value that is supplied by the current sensor (26, 28) with the expected current value, a plausibility check is performed on further measured values that are supplied by the current sensor (26, 28), in particular a decision is made as to whether the current sensor (26, 28) is defective.

2. Method according to Claim 1, wherein the electrical component (20, 22, 24) is pre-charged during the pre-charged phase (32) by way of a pre-charge resistor (18).

3. Method according to Claim 2, wherein the electrical component (20, 22, 24) is a capacitor (24) and the expected progression with respect to time of the pre-charge current during the pre-charge phase (32) corresponds to an exponential function.

4. Method according to Claim 1, wherein the electrical component (20, 22, 24) is pre-charged during the pre-charge phase (32) with a pre-charge current that is constant with respect to time.

5. Method according to any one of the preceding claims, wherein, on the basis of the comparison of the measured value that is supplied by the current sensor (26, 28) with the expected current value, the current sensor (26, 28) is calibrated and in particular the amplification factor and/or the offset of said current sensor is corrected.

6. Method according to any one of the preceding claims, wherein at least one measured value that is supplied by the current sensor (26, 28) prior to the commencement of the pre-charge phase (32) is used for the purpose of correcting the offset of the current sensor (26, 28).

7. Device comprising a microcontroller (36) and a current sensor (26, 28) that is designed for the purpose of measuring a battery current, **characterized in that** said device is designed for the purpose of performing a method according to any one of the preceding claims.

8. Battery (100) having a device according to Claim 7.

9. Vehicle, in particular an electric motor vehicle, comprising a device according to Claim 7 or a battery (100) according to Claim 8.

## Revendications

1. Procédé de vérification du bon fonctionnement d'un capteur de courant (26, 28) qui est conçu pour mesurer un courant de batterie d'une batterie (100), **caractérisé en ce que**, pendant une phase de précharge (32) commençant à un instant (34) lors duquel au moins un condensateur (24) est connecté à la batterie (100) et durant laquelle le condensateur (24) est préchargé par un courant de précharge mesuré par le capteur (26, 28), au moins une valeur de mesure fournie par le capteur de courant est comparée par une unité de calcul (36) à une valeur de courant attendue déterminée à partir d'une évolution temporelle attendue du courant de précharge stockée dans l'unité de calcul (36), et un contrôle de plausibilité d'autres valeurs de mesure délivrées par le capteur de courant (26, 28) est effectué sur la base de la comparaison de la valeur mesurée délivrée par le capteur de courant (26, 28) avec la valeur de courant attendue, et en particulier une décision est prise pour déterminer si le capteur de courant (26, 28) est défectueux.

2. Procédé selon la revendication 1, dans lequel le composant électrique (20, 22, 24) est préchargé pendant la phase de précharge (32) par l'intermédiaire d'une résistance de précharge (18).

3. Procédé selon la revendication 2, dans lequel le composant électrique (20, 22, 24) est un condensateur (24) et l'évolution temporelle attendue du courant de précharge pendant la phase de précharge (32) correspond à une fonction exponentielle.

4. Procédé selon la revendication 1, dans lequel le composant électrique (20, 22, 24) est préchargé pendant la phase de précharge (32) avec un courant de précharge qui est constant dans le temps.

5. Procédé selon l'une des revendications précédentes, dans lequel un étalonnage du capteur de courant (26, 28) est effectué sur la base de la comparaison de la valeur mesurée délivrée par le capteur de courant (26, 28) avec la valeur de courant attendue, et en particulier son facteur de gain et/ou son décalage est corrigé.

6. Procédé selon l'une des revendications précédentes, dans lequel au moins une valeur de mesure délivrée par le capteur de courant (26, 28) avant le début de la phase de précharge (32) est utilisée pour effectuer une correction du décalage du capteur de courant (26, 28).

7. Dispositif comprenant un microcontrôleur (36) et un capteur de courant (26, 28) qui est conçu pour mesurer un courant de batterie, **caractérisé en ce qu'**il est conçu pour mettre en oeuvre un procédé selon l'une des revendications précédentes.

8. Batterie (100) comportant un dispositif selon la revendication 7.

9. Véhicule automobile, en particulier véhicule automobile électrique, comprenant un dispositif selon la revendication 7 ou une batterie (100) selon la revendication 8.
